# EUROPEAN PATENT APPLICATION

(11) **EP 3 690 457 A1**
(43) Date of publication of application: **05.08.2020**
(21) Application number: 20305065.3
(22) Date of filing: 27.01.2020
(51) Int. Cl.: G01R 31/00, H02H 9/04, H02H 7/00

(54) **APPARATUS FOR MONITORING SURGE PROTECTION DEVICE AND METHOD OF ASSEMBLING THE SAME**

(30) Priority: 30.01.2019 CN 201910094085
(71) Applicant: Schneider Electric Industries SAS, 92500 Rueil Malmaison (FR)
(72) Inventor: LI, Xiaodong, Shanghai 201203 (CN); MA, Feng, Shanghai 201203 (CN)
(74) Representative: Manitz Finsterwald Patent- und Rechtsanwaltspartnerschaft mbB

(57) **Abstract**

The present disclosure provides an apparatus for monitoring a surge protection device and a method of assembling the same. An apparatus (100) for monitoring a surge protection device (102), comprises: a sensing module (104) disposed separate from the surge protection device (102), and configured to be electrically coupled to the surge protection device (102) and sense at least one current of an inrush current and a leakage current flowing through the surge protection device (102), to generate a sensing signal representing the at least one current; and a signal processing module (106) disposed separate from the surge protection device (102), and configured to be electrically coupled to the sensing module (104) and receive the sensing signal from the sensing module (104), to perform signal processing on the sensing signal.

## Description

### FIELD

The present disclosure generally relates to the field of surge protection devices, and specifically to an apparatus for monitoring a surge protection device and a method of assembling the same.

### BACKGROUND

Surge protection devices (SPDs) serve as electronic devices that provide safety protection for various electronic equipment and communication lines. When a peak current or voltage is suddenly generated in an electrical circuit or communication line due to external interference, the surge protection device can conduct in an extremely short period of time for shunting, thereby preventing the surge from damaging the electrical circuit or communication line.

A majority of surge protection devices that have been proposed only have a surge protection function, which cannot monitor or record the surge, and they cannot predict a service life of the surge protection device based on a situation of the surge. For example, the proposed surge protection devices only have a surge counting function, which can only perform a simple counting, and cannot detect a peak value of an inrush current and its related time.

Therefore, it is desirable to provide such an accessory product or apparatus for monitoring the surge protection device, which has a function of recording the surges in the surge protection device and a function of predicting the service life of the surge protection device.

### SUMMARY

Embodiments of the present disclosure are directed to an apparatus for monitoring a surge protection device with improved performance and a method of assembling the same.

According to one aspect, there is provided an apparatus for monitoring a surge protection device. The apparatus comprises: a sensing module disposed separate from the surge protection device, and configured to be electrically coupled to the surge protection device and sense at least one current of an inrush current and a leakage current flowing through the surge protection device, to generate a sensing signal representing the at least one current; and a signal processing module disposed separate from the surge protection device, and configured to be electrically coupled to the sensing module and receive the sensing signal from the sensing module, to perform signal processing on the sensing signal.

In some embodiments, the sensing module comprises at least one of the following: at least one inrush current sensor, each inrush current sensor configured to sense the inrush current flowing through the surge protection device to generate a first sensor signal representing the inrush current; at least one leakage current sensor, each leakage current sensor configured to sense the leakage current flowing through the surge protection device to generate a second sensor signal representing the leakage current.

In some embodiments, the sensing module further comprises: a first housing disposed separate from the surge protection device, and adapted to accommodate the inrush current sensor and the leakage current sensor.

In some embodiments, the signal processing module comprises: a calculation module configured to receive the sensing signal from the sensing module to perform the signal processing on the sensing signal; and a second housing disposed separate from the surge protection device, and adapted to accommodate the calculation module.

In some embodiments, the calculation module is further configured to perform at least one of: recording the sensing signal in real time; determining a peak value and a waveform duration of the sensing signal within a predetermined period of time; determining an estimated service life of the surge protection device based on the sensing signal; and sending a warning message based on the sensing signal.

In some embodiments, the signal processing module further comprises: a power supply module accommodated in the second housing, and configured to supply power to the calculation module.

In some embodiments, the signal processing module further comprises: a communication module accommodated in the second housing, and configured to communicate with an external device.

In some embodiments, the signal processing module further comprises: a shielding module accommodated in the second housing, and configured to shield electromagnetic interference for the calculation module.

In some embodiments, the inrush current sensors are configured to sense the inrush currents flowing through respective poles of the surge protection device, respectively, and the leakage current sensors are configured to sense the leakage currents flowing through the respective poles of the surge protection device, respectively.

In some embodiments, the inrush current sensor is configured to sense a total inrush current flowing through the surge protection device, and the leakage current sensor is configured to sense a total leakage current flowing through the surge protection device.

In some embodiments, the sensing module comprises: a first sub-module having a housing disposed separate from the surge protection device and comprising the inrush current sensors, the inrush current sensors accommodated in the housing of the first sub-module and configured to sense the inrush currents flowing through respective poles of the surge protection device, respectively; and a second sub-module having a housing disposed separate from the surge protection device and comprising the leakage current sensor, the leakage current sensor accommodated in the housing of the second sub-module and configured to sense a total leakage current flowing through the surge protection device.

In some embodiments, the sensing module comprises: a third sub-module having a housing disposed separate from the surge protection device and comprising the leakage current sensors, the leakage current sensors accommodated in the housing of the third sub-module and configured to sense the leakage currents flowing through respective poles of the surge protection device, respectively; and a fourth sub-module having a housing disposed separate from the surge protection device and comprising the inrush current sensor, the inrush current sensor accommodated in the housing of the fourth sub-module and configured to sense a total inrush current flowing through the surge protection device.

In some embodiments, the sensing module is mechanically coupled to the signal processing module.

According to another aspect, there is provided a monitoring system. The monitoring system comprises: at least one apparatus as described above; and a host configured to communicate with the apparatus.

According to yet another aspect, there is provided a method for assembling the above-mentioned apparatus. The method comprises: electrically coupling the sensing module to the surge protection device; and electrically coupling the signal processing module to the sensing module.

According to the embodiments of the present disclosure, the apparatus for monitoring the surge protection device allows for flexible and accurate selection and configuration of corresponding sensing module and signal processing module for the surge protection device, facilitates troubleshooting and replacement of faulty modules without replacing normal modules, and monitors and records the parameters and status of the surge protection device in a less complicated and highly reliable way in order to predict the service life of the surge protection device and send the warning.

### BRIEF DESCRIPTION OF THE DRAWINGS

FIG. 1 illustrates a schematic diagram of an apparatus for monitoring a surge protection device according to an embodiment of the present disclosure;
FIG. 2 illustrates an exploded schematic diagram of a sensing module according to an embodiment of the present disclosure;
FIG. 3 illustrates an exploded schematic diagram of a signal processing module according to an embodiment of the present disclosure;
FIG. 4 illustrates an exploded schematic diagram of a housing of a signal processing module according to an embodiment of the present disclosure;
FIG. 5 illustrates an exploded schematic diagram of a housing of a sensing module according to an embodiment of the present disclosure;
FIG. 6 illustrates a schematic diagram of a first arrangement of an apparatus for monitoring a surge protection device according to an embodiment of the present disclosure;
FIG. 7 illustrates a schematic diagram of a second arrangement of an apparatus for monitoring a surge protection device according to an embodiment of the present disclosure;
FIG. 8 illustrates a schematic diagram of a third arrangement of an apparatus for monitoring a surge protection device according to an embodiment of the present disclosure;
FIG. 9 illustrates a schematic diagram of a fourth arrangement of an apparatus for monitoring a surge protection device according to an embodiment of the present disclosure; and
FIG. 10 illustrates a block diagram of a system for monitoring a surge protection device according to an embodiment of the present disclosure.

It should be understood that various elements in the drawings are not drawn to scale and the same reference numerals are used to identify the same elements shown in one or more figures.

### DETAILED DESCRIPTION OF EMBODIMENTS

The detailed description set forth below with reference to the drawings is intended as a description of various configurations and is not intended to represent a sole configuration that may practice concepts described herein. The detailed description comprises specific details for the purpose of providing a thorough understanding of the various concepts. However, it is very apparent to a person skilled in the art that these concepts may be practiced without these specific details. In some cases, to avoid obscuring such concepts, well-known structures and components are shown in block diagram form.

As mentioned above, it is desirable to provide a solution with a function of recording surges in a surge protection device and a function of predicting a service life of the surge protection device. In this regard, an integrated smart surge protection device has recently been proposed as a product that integrates the surge protection device with the surge recording function and the service life predicting function. In the case of a failure of the integrated smart surge protection device, the whole product needs to be replaced. However, at this time, the surge recording function and the service life predicting function of the product may not have failed, and the replacement of the whole product caused a waste of available resources. In addition, the inrush current flowing in the integrated smart surge protection device may cause strong electromagnetic interference to other components in the product and affect service life and reliability of these components. Furthermore, in the case of a failure of these components, the surge protection device that can continue to operate normally also needs to be replaced along with the whole product. In addition, due to high integration of the product, there are also many design constraints for various components within the product. Therefore, in view of the limitations existing in the integrated smart surge protection device, it is desirable to provide an improved solution having a function of recording the surges in the surge protection device and a function of predicting the service life of the surge protection device.

In general, embodiments of the present disclosure provide a separate modular accessory product or apparatus for monitoring the surge protection device, which comprises a sensing module and a signal processing module which are provided separate from the surge protection device. The sensing module is configured to be electrically coupled to the surge protection device, and sense at least one current of an inrush current and a leakage current flowing through the surge protection device to generate a sensing signal representing the at least one current. The signal processing module is configured to be electrically coupled to the sensing module, and receive the sensing signal from the sensing module to perform signal processing on the sensing signal. The apparatus for monitoring the surge protection device according to embodiments of the present disclosure is divided into the sensing module and the signal processing module, and both of them are spliced into an accessory product for the surge protection device, so that the apparatus can be flexibly matched with the surge protection device, monitor the leakage current and inrush current of the surge protection device, and predict the service life of the surge protection device, and that a faulty module can be replaced individually when a fault occurs.

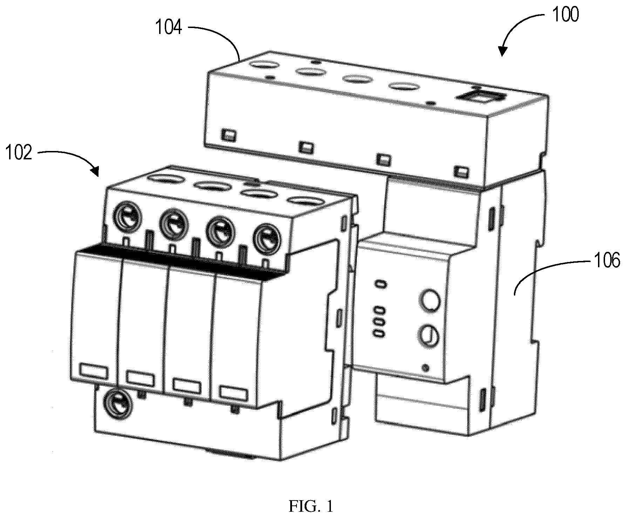

FIG. 1 illustrates a schematic diagram of the apparatus for monitoring the surge protection device according to an embodiment of the present disclosure. As shown, the apparatus 100 for monitoring the surge protection device 102 comprises a sensing module 104 and a signal processing module 106. In some embodiments, the surge protection device 102 is any type of surge protection device known in the art.

The sensing module 104 is disposed separate from the surge protection device 102. The sensing module 104 is configured to be electrically coupled to the surge protection device 102, and sense at least one current of an inrush current and a leakage current flowing through the surge protection device 102 to generate a sensing signal representing the at least one current. In some embodiments, the sensing module 104 may comprise an inrush current sensor to sense the inrush current flowing through the surge protection device 102. In some embodiments, the sensing module 104 may comprise a leakage current sensor to sense the leakage current flowing through the surge protection device 102. In some embodiments, the sensing module 104 may further comprise a voltage sensor to sense an operating voltage and/or an overvoltage of the surge protection device 102.

The signal processing module 106 is disposed separate from the surge protection device 102. The signal processing module 106 is configured to be electrically coupled to the sensing module 104, and receive the sensing signal from the sensing module 104 to perform signal processing on the sensing signal. In some embodiments, the signal processing module 106 records the inrush current and/or the inrush current peak of the surge protection device 102 based on the sensing signal. In some embodiments, the signal processing module 106 records the leakage current of the surge protection device 102 based on the sensing signal. In some embodiments, the signal processing module 106 records the operating voltage and/or overvoltage of the surge protection device 102 based on the sensing signal. In some embodiments, the signal processing module 106 predicts a service life of the surge protection device based on the sensing signal, and sends a warning message when certain conditions are met. It should be understood that the process for predicting the service life of the surge protection device may be any process known in the art for performing service life prediction based on the inrush current and/or leakage current or other parameters. In some embodiments, the signal processing module 106 may record the sensing signal and information associated with the sensing signal over time.

In some embodiments, the sensing module 104 is mechanically coupled to the signal processing module 106. In some embodiments, the sensing module 104 is spaced apart from the surge protection device 102 by a suitable distance. In some embodiments, the signal processing module 106 is spaced apart from the surge protection device 102 by a suitable distance. In other embodiments, the sensing module 104 may contact with the surge protection device 102. At this time, the wording "disposed separate from" means that the sensing module 104 and the surge protection device 102 are two independent products manufactured separately, rather than a whole product integrating the two. In other embodiments, similarly, the signal processing module 106 may contact with the surge protection device 102. In some embodiments, the signal processing module 106 is disposed separate from the sensing module 104. At this time, as described above, the signal processing module 106 may contact with the sensing module 104.

According to the embodiment of the present disclosure, the sensing module 104 and the signal processing module 106 are independent products or accessory products disposed separate from the surge protection device 102. The shapes and specifications of the sensing module 104 and the signal processing module 106 may be adjusted based on the surge protection device 102, and the sensing module 104 and the signal processing module 106 may be detachably mounted to the surge protection device 102. The separate modular design of the sensing module 104 and the signal processing module 106 allows the faulty module to be replaced individually, promotes maintenance flexibility and reduces maintenance costs, allows for reduction of the interference caused by the surge protection device 102 to the sensing module 104 and/or signal processing module 106, and improves the reliability and service life of the apparatus.

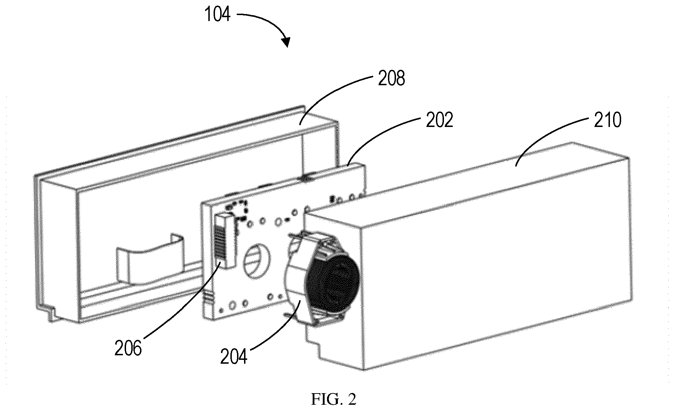

FIG. 2 illustrates an exploded schematic diagram of the sensing module according to an embodiment of the present disclosure. As shown in FIG. 2, the sensing module 104 comprises at least one inrush current sensor 202 and at least one leakage current sensor 204. It should be understood that although FIG. 2 shows that the sensing module 104 comprises both the inrush current sensor 202 and the leakage current sensor 204, in other embodiments, the sensing module 104 may comprise one of the inrush current sensor 202 and the leakage current sensor 204.

The inrush current sensor 202 is configured to sense the inrush current flowing through the surge protection device 102 to generate a sensor signal representing the inrush current. In some embodiments, the inrush current sensor 202 comprises a substrate that is configured to allow cables of corresponding poles of the surge protection device 102 to pass through the substrate. In some embodiments, a plurality of inrush current sensors 202 share a substrate, that is, sensing elements of the plurality of inrush current sensors 202 are disposed on the substrate. In some embodiments, the number of inrush current sensors 202 corresponds to the number of poles of the surge protection device 102. It should be understood that the inrush current sensor 202 may be any type of inrush current sensor known in the art.

The leakage current sensor 204 is configured to sense a leakage current flowing through the surge protection device 102 to generate a sensor signal representing the leakage current. In some embodiments, the leakage current sensor 204 is disposed on the substrate of the inrush current sensor 202. In some embodiments, the number of the leakage current sensors 204 corresponds to the number of poles of the surge protection device 102. It should be understood that the leakage current sensor 204 may be any type of leakage current sensor known in the art.

In some embodiments, the sensing module 104 further comprises an electrical connection port 206 to output the sensed signal to the signal processing module 106 via the electrical connection port 206. In some embodiments, the electrical connection port 206 is disposed on the substrate of the inrush current sensor 202.

As shown in FIG. 2, the sensing module 104 further comprises housings 208 and 210. The housings 208 and 210 are adapted to be coupled to each other to form a unitary housing for accommodating the inrush current sensor 202 and the leakage current sensor 204 within the housings 208 and 210. In some embodiments, the housings 208 and 210 are adapted to house all components of the sensing module 104. In some embodiments, the housings 208 and 210 are provided separate from the surge protection device 102. In some embodiments, the housings 208 and 210 are shaped to be adapted to electrically couple the sensing module 104 to the surge protection device 102. In some embodiments, the sizes of the housings 208 and 210 are designed to match the size of the surge protection device 102. It should be understood that the shapes of the housings 208 and 210 are not limited to those shown in FIG. 2, and may employ any other suitable shape.

According to an embodiment of the present disclosure, the inrush current sensor 202 and the leakage current sensor 204 may be included in the sensing module 104 disposed separate from the surge protection device 102. By selecting configurations of the inrush current sensor 202 and the leakage current sensor 204 for respective poles of the surge protection device 102 according to different types of the surge protection device 102, it is possible to desirably configure a proper sensing module 104 to flexibly match with the surge protection device 102. In addition, in the event of a failure, the separate modular design facilitates troubleshooting and replacement of corresponding modules.

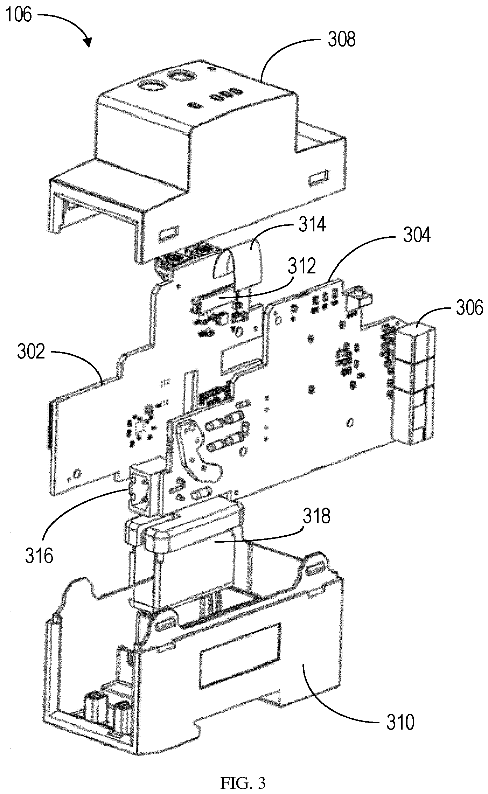

FIG. 3 illustrates an exploded schematic diagram of the signal processing module according to an embodiment of the present disclosure. As shown in FIG. 3, the signal processing module 106 comprises a calculation module 302 configured to receive the sensing signal from the sensing module 104 to perform signal processing on the sensing signal. In some embodiments, the calculation module 302 is further configured to record the sensing signal in real time, determine a peak value and a waveform duration of the sensing signal within a predetermined time period, determine an estimated service life of the surge protection device 102 based on the sensing signal, or send a warning message based on the sensing signal. In some embodiments, the calculation module 302 is configured to store and calculate an input signal representing the inrush current or the leakage current of the surge protection device 102. In some embodiments, the calculation module 302 is configured to store and calculate an input signal representing the operating voltage or the overvoltage of the surge protection device 102. In some embodiments, the calculation module 302 predicts the service life of the surge protection device and gives an early warning based on processes known in the art. For example, the calculation module 302 can predict and analyze the service life of the surge protection device 102 according to a known algorithm developed by Schneider Electric Co., Ltd. It should be understood that the calculation module 302 may comprise any type of signal processing unit known in the art.

As shown in FIG. 3, the signal processing module 106 comprises a power supply module 304 configured to supply power to the calculation module 302. In some embodiments, the power supply module 304 is configured to convert power accommodated from the external into power suitable for the signal processing module 106, particularly the calculation module 302. In some embodiments, the power supply module 304 may comprise a power supply port 316. In other embodiments, the power supply module 304 may comprise any type of battery. In some embodiments, the power supply module 304 may be further configured to power the components within the sensing module 104.

In some embodiments, the calculation module 302 and the power supply module 304 comprise substrates different from each other. In some embodiments, a first substrate of the calculation module 302 and a second substrate of the power supply module 304 are disposed separate from each other. In some embodiments, the sizes of the first substrate and the second substrate are designed to match that of the surge protection device 102. It should be understood that the calculation module 302 and the power supply module 304 are not limited to the separate configuration shown in FIG. 2. In other embodiments, the calculation module 302 and the power supply module 304 may share one substrate.

In some embodiments, the calculation module 302 comprises an electrical connection port 312 and an electrical connection line 314, to be electrically coupled to the power supply module 304 through the electrical connection port 312 via the electrical connection line 314.

As shown in FIG. 3, the signal processing module 106 further comprises a communication module 306 configured to communicate with an external device. In some embodiments, the communication module 306 is configured to communicate with the external device in a wireless or wired manner. In some embodiments, the communication module 306 is configured to send a signal output by the calculation module 302 to the external device. In some embodiments, the communication module 306 is configured to send signals associated with the power supply module 304 to the external device. In some embodiments, the communication module 306 is configured to enable remote output of all data and calculation results of the signal processing module 106. In some embodiments, the communication module 306 is further configured to be communicatively coupled to a telesignalling port of the surge protection device 102, to indicate states of the surge protection device 102 and its backup protection device according to signals of the telesignalling port of the surge protection device 102 and the telesignalling port of the backup surge protection device. In some embodiments, the communication module 306 is disposed on the first substrate of the calculation module 302 or the second substrate of the power supply module 304.

As shown in FIG. 3, the signal processing module 106 further comprises housings 308 and 310. The housings 308 and 310 are adapted to be coupled to each other to form a unitary housing for accommodating the calculation module 302, the power supply module 304 and the communication module 306. In some embodiments, the housings 308 and 310 are adapted to house all components of the signal processing module 106. In some embodiments, the housings 308 and 310 are disposed separate from the surge protection device 102. In some embodiments, the housings 308 and 310 are shaped to be adapted to electrically couple the signal processing module 106 to the sensing module 104. In some embodiments, the sizes of the housings 308 and 310 are designed to match that of the surge protection device 102. It should be understood that the shapes of the housings 308 and 310 are not limited to those shown in FIG. 3, and may employ any other suitable shape.

As shown in FIG. 3, the signal processing module 106 further comprises a shielding module 318, which is accommodated in the housings 308 and 310 and configured to shield electromagnetic interference to the calculation module 302. In some embodiments, the shielding module 318 is configured to shield the influence exerted by the electromagnetic field generated by the surge protection device 102 on the calculation module 302. In this way, the separate modular design is used to prevent the external interference from affecting the calculation module 302 by disposing the proper shielding module 318, thereby improving the accuracy, reliability and service life of the signal processing module 106.

In some embodiments, the housings 208 and 210 of the sensing module 104 are mechanically coupled to the housings 308 and 310 of the signal processing module 106. In some embodiments, the housings 208 and 210 are detachably coupled to the housings 308 and 310. In some embodiments, the housings 208 and 210 are fixedly coupled to the housings 308 and 310. In some embodiments, the housings 208 and 210 are coupled to the housings 308 and 310 to be movable with each other. It should be understood that the housings 208 and 210 of the sensing module 104 may be coupled to the housings 308 and 310 of the signal processing module 106 in any known mechanical coupling manner.

According to an embodiment of the present disclosure, the calculation module 302, the power supply module 304, the communication module 306 and the shielding module 318 may be included in the signal processing module 106 disposed separate from the surge protection device 102 and the sensing module 104. By selecting corresponding configurations for components in the signal processing module 106 according to different surge level demands of the surge protection device 102 and the specification of the sensing module 104, it is possible to desirably configure a proper signal processing module 106 to flexibly match with the surge protection device 102. In addition, in the event of a failure, the separate modular design facilitates troubleshooting and replacement of corresponding modules.

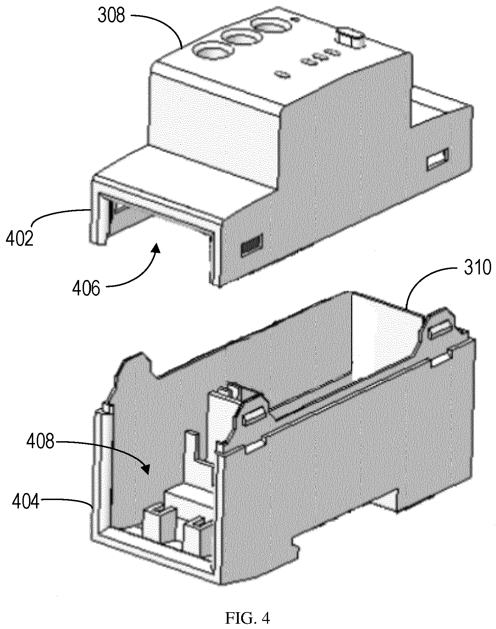

FIG. 4 illustrates an exploded schematic diagram of the housings of the signal processing module according to an embodiment of the present disclosure. As shown in FIG. 4, the housing 308 comprises a first end portion 402, and a first opening 406 is formed in the first end portion 402. In addition, the housing 310 comprises a second end portion 404, and a second opening 408 is formed in the second end portion 404. In a case where the housings 308 and 310 are coupled together, an opening of the signal processing module 104 is formed in the first end portion 402 and second end portion 404 which are coupled to each other, i.e., the first opening 406 and the second opening 408 are adapted to form the opening together.. In some embodiments, the first end portion 402 and the second end portion 404 coupled to each other are coupled to the housings 208 and 210 of the sensing module 104. In some embodiments, various components of the signal processing module 106 are electrically connected to the sensing module 104 through the opening.

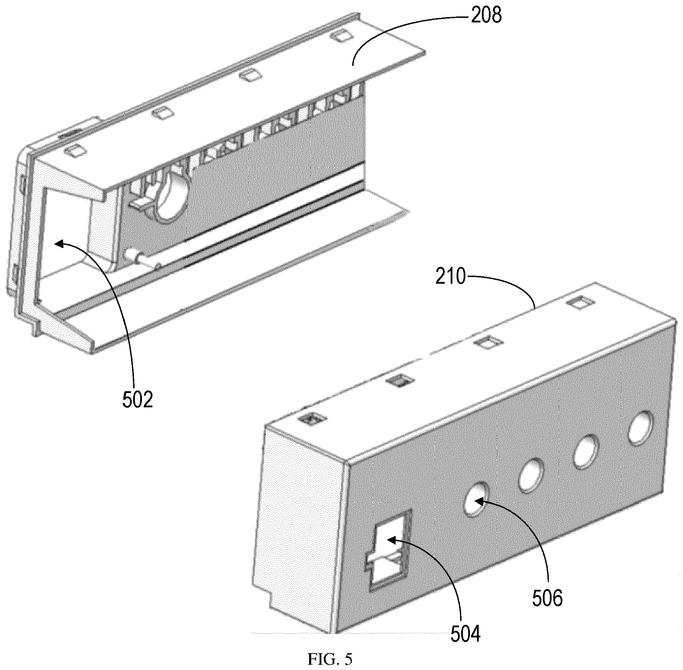

FIG. 5 illustrates an exploded schematic diagram of the housings of the sensing module according to an embodiment of the present disclosure. As shown in FIG. 5, the housing 208 comprises an opening 502. The first end portion 402 and the second end portion 404 as shown in FIG. 4 are adapted to be inserted into the opening 502 such that the housings 308 and 310 of the signal processing module 106 are coupled to the housings 208 and 210 of the sensing module 104. The housing 210 comprises a terminal opening 504 such that the power supply port 316 of the power supply module 304 in the signal processing module 106 shown in FIG. 3 is exposed to the external through the terminal opening 504 of the housing 210 for electrical connection with an external power supply. In some embodiments, the housing 210 comprises a cable opening 506 through which the cable of the surge protection device 102 passes. In some embodiments, the number of cable openings 506 is equal to the number of poles of the surge protection device 102. It should be understood that the housing 208 also comprises an opening corresponding to the cable opening 506.

According to an embodiment of the present disclosure, the apparatus 100 for monitoring the surge protection device 102 is divided into the sensing module 104 and the signal processing module 106 which are disposed separate from the surge protection device 102, and the two are spliced into an accessory product for the surge protection device 102. The specifications and sizes of the housings of the sensing module 104 and the signal processing module 106 are respectively designed to flexibly match with the surge protection device 102, occupy a reasonable space and promote the installation and maintenance of the apparatus 100. With a less complex, separate modular design, the apparatus 100 can monitor the inrush current, the leakage current, the voltage or the status of the surge protection device 102 and predict the service life of the surge protection device 102 and send a warning message based on the sensed signals. In addition, the surge protection device 102 and the sensing module 104 and the signal processing module 106 in the apparatus 100 may be conveniently replaced individually as needed.

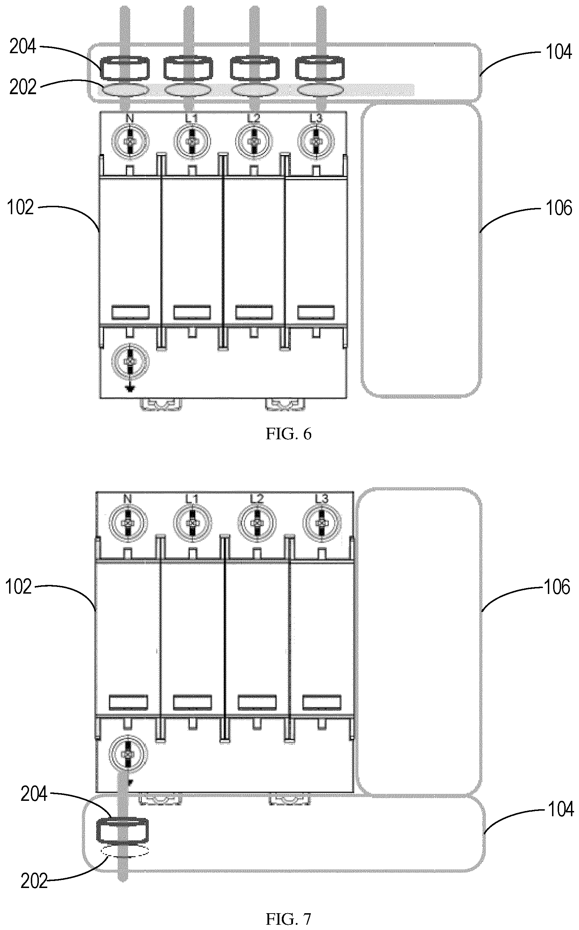

FIG. 6 illustrates a schematic diagram of a first arrangement of the apparatus for monitoring the surge protection device according to an embodiment of the present disclosure. As shown in FIG. 6, the sensing module 104 comprises a plurality of inrush current sensors 202 and a plurality of leakage current sensors 204. The plurality of inrush current sensors 202 are configured to respectively sense the inrush currents flowing through respective poles of the surge protection device 102. The plurality of leakage current sensors 204 are configured to respectively sense the leakage currents flowing through respective poles of the surge protection device 102. Such an arrangement may satisfy the measurement of the inrush current and the leakage current of each pole of the surge protection device 102, so that the signal processing module 106 can accurately perform service life assessment and warning on each pole of the surge protection device 102, and may replace one or more poles in the surge protection device according to the warning message.

FIG. 7 illustrates a schematic diagram of a second arrangement of the apparatus for monitoring the surge protection device according to an embodiment of the present disclosure. As shown in FIG. 7, the sensing module 104 comprises one inrush current sensor 202 and one leakage current sensor 204. The inrush current sensor 202 is configured to sense a total inrush current flowing through the surge protection device 102, and the leakage current sensor 204 is configured to sense a total leakage current flowing through the surge protection device 102. Such an arrangement may allow the total inrush current and total leakage current of the surge protection device 102 to be measured, so that the signal processing module 106 monitors and warns the entire product of the surge protection device according to the sensed signal.

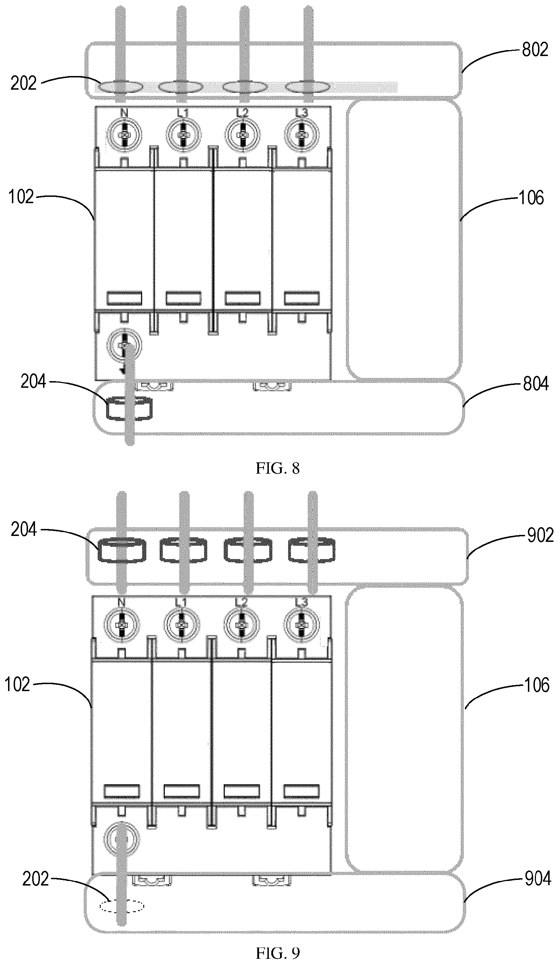

FIG. 8 illustrates a schematic diagram of a third arrangement of the apparatus for monitoring the surge protection device according to an embodiment of the present disclosure. As shown in FIG. 8, the sensing module 104 comprises a first sub-module 802 and a second sub-module 804. The first sub-module 802 has a housing disposed separate from the surge protection device 102 and comprises a plurality of inrush current sensors 202. The plurality of inrush current sensors 202 are accommodated within the housing of the first sub-module 802 and are configured to sense the inrush currents flowing through respective poles of the surge protection device 102, respectively. The second sub-module 804 has a housing disposed separate from the surge protection device 102 and comprises one leakage current sensor 204. The leakage current sensor 204 is accommodated in a housing of the second sub-module 804 and is configured to sense the total leakage current flowing through the surge protection device 102. Such an arrangement divides the sensing module 104 into two parts, one part is the first sub-module 802 for measuring the inrush current of each pole of the surge protection device 102, and the other part is the second sub-module 804 for measuring the total leakage current of the surge protection device 102, such that the signal processing module 106 may perform service life assessment and warning on each pole of the surge protection device 102 according to the inrush current of each pole of the surge protection device 102, and perform service life assessment and warning on the whole product of the surge protection device 102 according to the total leakage current of the surge protection device 102.

FIG. 9 illustrates a schematic diagram of a fourth arrangement of the apparatus for monitoring the surge protection device according to an embodiment of the present disclosure. As shown in FIG. 9, the sensing module 104 comprises a third sub-module 902 and a fourth sub-module 904. The third sub-module 902 has a housing disposed separate from the surge protection device 102 and comprises a plurality of leakage current sensors 204. The plurality of leakage current sensors 204 are accommodated in a housing of the third sub-module 902 and are configured to sense the leakage currents flowing through respective poles of the surge protection device 102, respectively. The fourth sub-module 904 has a housing disposed separate from the surge protection device 102 and comprises one inrush current sensor 202. The inrush current sensor 202 is accommodated in a housing of the fourth sub-module 904 and is configured to sense the total inrush current flowing through the surge protection device 102. Such an arrangement divides the sensing module 104 into two parts, one part is the third sub-module 902 for measuring the leakage current of each pole of the surge protection device 102, and the other part is the fourth sub-module 904 for measuring the total inrush current of the surge protection device 102, so that the signal processing module 106 may perform service life assessment and warning on each pole of the surge protection device 102 according to the leakage current of each pole of the surge protection device 102, and perform service life assessment and warning on the whole product of the surge protection device 102 according to the total inrush current of the surge protection device 102.

Although FIGS. 6-9 show that the surge protection device 102 comprises four poles and a number of sensors corresponding thereto, the present disclosure is not limited thereto. In other embodiments, the surge protection device 102 may comprise any other number of poles, and both the number of the inrush current sensors 202 and the number the leakage current sensors 204 correspond thereto.

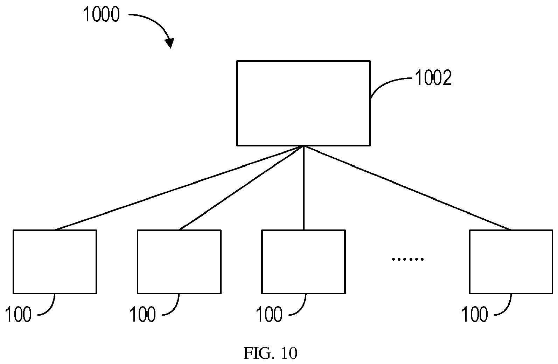

FIG. 10 illustrates a block diagram of a system for monitoring the surge protection device according to an embodiment of the present disclosure. As shown in FIG. 10, a monitoring system 1000 comprises one or more apparatuses 100 for monitoring the surge protection devices 102. The monitoring system 1000 further comprises a host 1002, and the one or more apparatuses 100 may be communicatively coupled to the host 1002 in a wired or wireless manner. In some embodiments, the host 1002 may be configured to monitor and record parameters of the surge protection device 102 sensed by the apparatuses 100. In some embodiments, the host 1002 may be further configured to control operation and/or configurations of the apparatuses 100. In some embodiments, the host 1002 may monitor the telesignalling of the surge protection device and the status of the backup protection device through the apparatuses 100.

According to an embodiment of the present disclosure, a method for assembling the apparatus 100 may comprise electrically coupling the sensing module 104 disposed separate from the surge protection device 102 to the surge protection device 102, and electrically coupling the signal processing module 106 disposed separate from the surge protection device 102 and sensing module 104 to the sensing module 104. In some embodiments, the sensing module 104 matching with the surge protection device 102 is selected from sensing modules which have been already individually manufactured, and the selected sensing module 104 is placed on a side of the surge protection device 102 to electrically couple the sensing module 104 to the surge protection device 102. In some embodiments, the signal processing module 106 respectively matching with the surge protection device 102 and sensing module 104 is selected from signal processing modules which have been already individually manufactured, and the selected signal processing module 106 is placed on another side of the surge protection device 102 and a side of the sensing module 104, to electrically couple the signal processing module 106 to the sensing module 104.

According to the embodiments of the present disclosure, the separate modular design of the apparatus for monitoring the surge protection device allows for flexible and accurate selection and configuration of corresponding sensing module and signal processing module for the surge protection device, facilitates troubleshooting and replacement of faulty modules without replacing normal modules, and monitors and records the parameters and status of the surge protection device in a less complicated and highly reliable way in order to predict the service life of the surge protection device and send the warning.

The previous description of the present disclosure is provided to enable any person skilled in the art to make or use the disclosure. Well-known elements will not be described in detail or omitted so as not to obscure the relevant details of aspects and examples disclosed herein. It will be apparent to those skilled in the art that various changes and modifications can be made without departing from the scope of the disclosure as defined by the claims. Accordingly, the disclosure is not intended to be limited to the examples described herein, but to conform to the widest scope consistent with the principles and novel features disclosed herein.

## Claims

1. An apparatus (100) for monitoring a surge protection device (102), comprising:
a sensing module (104) disposed separate from the surge protection device (102), and configured to be electrically coupled to the surge protection device (102) and sense at least one current of an inrush current and a leakage current flowing through the surge protection device (102), to generate a sensing signal representing the at least one current; and
a signal processing module (106) disposed separate from the surge protection device (102), and configured to be electrically coupled to the sensing module (104) and receive the sensing signal from the sensing module (104), to perform signal processing on the sensing signal.

2. The apparatus (100) of claim 1, wherein the sensing module (104) comprises at least one of:
at least one inrush current sensor (202), each inrush current sensor (202) configured to sense the inrush current flowing through the surge protection device (102) to generate a first sensor signal representing the inrush current;
at least one leakage current sensor (204), each leakage current sensor (204) configured to sense the leakage current flowing through the surge protection device (102) to generate a second sensor signal representing the leakage current.

3. The apparatus (100) of claim 2, wherein the sensing module (104) further comprises:
a first housing (208, 210) disposed separate from the surge protection device (102), and adapted to accommodate the inrush current sensor (202) and the leakage current sensor (204).

4. The apparatus (100) of claim 1, wherein the signal processing module (106) comprises:
a calculation module (302) configured to receive the sensing signal from the sensing module (104) to perform the signal processing on the sensing signal; and
a second housing (308, 310) disposed separate from the surge protection device (102), and adapted to accommodate the calculation module (302).

5. The apparatus (100) of claim 4, wherein the calculation module (302) is further configured to perform at least one of:
recording the sensing signal in real time;
determining a peak value and a waveform duration of the sensing signal within a predetermined period of time;
determining an estimated service life of the surge protection device (102) based on the sensing signal;
sending a warning message based on the sensing signal.

6. The apparatus (100) of claim 4, wherein the signal processing module (106) further comprises:
a power supply module (304) accommodated in the second housing (308, 310), and configured to supply power to the calculation module (302).

7. The apparatus (100) of claim 4, wherein the signal processing module (106) further comprises:
a communication module (306) accommodated in the second housing (308, 310), and configured to communicate with an external device.

8. The apparatus (100) of claim 4, wherein the signal processing module (106) further comprises:
a shielding module (318) accommodated in the second housing (308, 310), and configured to shield electromagnetic interference for the calculation module (302).

9. The apparatus (100) of claim 3, wherein the inrush current sensors (202) are configured to sense the inrush currents flowing through respective poles of the surge protection device (102), respectively, and the leakage current sensors (204) are configured to sense the leakage currents flowing through the respective poles of the surge protection device (102), respectively.

10. The apparatus (100) of claim 3, wherein the inrush current sensor (202) is configured to sense a total inrush current flowing through the surge protection device (102), and the leakage current sensor (204) is configured to sense a total leakage current flowing through the surge protection device (102).

11. The apparatus (100) of claim 2, wherein the sensing module (104) comprises:
a first sub-module (802) having a housing disposed separate from the surge protection device (102) and comprising the inrush current sensors (202), the inrush current sensors (202) accommodated in the housing of the first sub-module (802) and configured to sense the inrush currents flowing through respective poles of the surge protection device (102), respectively; and
a second sub-module (804) having a housing disposed separate from the surge protection device (102) and comprising the leakage current sensor (204), the leakage current sensor (204) accommodated in the housing of the second sub-module (804) and configured to sense a total leakage current flowing through the surge protection device (102).

12. The apparatus (100) of claim 2, wherein the sensing module (104) comprises:
a third sub-module (902) having a housing disposed separate from the surge protection device (102) and comprising the leakage current sensors (204), the leakage current sensors (204) accommodated in the housing of the third sub-module (902) and configured to sense the leakage currents flowing through respective poles of the surge protection device (102), respectively; and
a fourth sub-module (904) having a housing disposed separate from the surge protection device (102) and comprising the inrush current sensor (202), the inrush current sensor (202) accommodated in the housing of the fourth sub-module (904) and configured to sense a total inrush current flowing through the surge protection device (102).

13. The apparatus (100) of any of claims 1-12, wherein the sensing module (104) is mechanically coupled to the signal processing module (106).

14. A monitoring system (1000), comprising:
at least one apparatus (100) of any of claims 1-13; and
a host (1002) configured to communicate with the apparatus (100).

15. A method for assembling the apparatus (100) of any of claims 1-13, comprising:
electrically coupling the sensing module (104) to the surge protection device (102); and
electrically coupling the signal processing module (106) to the sensing module (104).
